# EUROPEAN PATENT APPLICATION

(11) **EP 4 492 433 A1**
(43) Date of publication of application: **15.01.2025**
(21) Application number: 24187794.3
(22) Date of filing: 10.07.2024
(51) Int. Cl.: H01L 21/20, H01L 21/02

(54) **PROCESS FOR GROWING ACTIVE LAYERS IN SEQUENCE**

(30) Priority: 12.07.2023 IT 202300014544
(71) Applicant: LPE S.p.A., 20021 Baranzate (MI) (IT)
(72) Inventor: FRANCO, GIOVANNI, I-20021 BARANZATE, MILANO (IT)
(74) Representative: Croce, Valeria

(57) **Abstract**

The present invention describes a process for producing silicon carbide substrates which reduces the crystallographic defects.

## Description

The present invention relates to the field of semiconductor production, and in particular to the production of silicon carbide substrates.

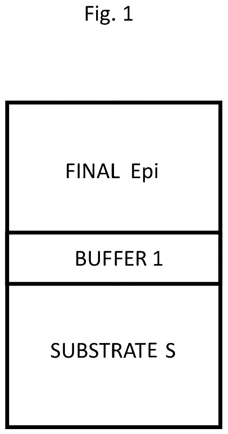

A silicon carbide substrate produced according to the prior art is for example shown in figure 1.

In particular, such a technique is defined as "single buffer" and comprises a lower layer S, a first buffer layer B1, and a final epitaxial layer.

The buffer layer B1 has a thickness ranging from 0.1 µm to a few µm.

This procedure allows closing crystallographic defects up to 90-99%; this means that 1% to 10% of crystallographic defects remain in the crystalline matrix.

Defects in SiC wafer are interruptions in the periodic crystalline structure, and may be distinguished between:
(1) crystallographic defects within the wafer (such as, but not limited to: dislocations, stacking faults and point defects), and
(2) surface defects at or near the wafer surface (such as, but not limited to: "carrots", polytype inclusions, often referred to as triangular defects, and scratches).

It is known that the performance of SiC devices is chiefly determined by the presence of so-called killer defects, which are formed during crystal growth.

Defects in the crystallographic structure penalize and jeopardize the performance of the products incorporating them.

For this, there are provided reliability assessments (burn-in tests), and downstream of the production, a very strict quality control.

Taking into account the fact that silicon carbide SiC semiconductors find application in a very wide range of electronic products today, in particular in the aeronautical, aerospace and automotive fields; their demand is constantly growing.

The manufacturing industry is therefore faced with the challenge of producing high-quality silicon carbide SIC semiconductors.

Therefore, reducing the possibility of defects, and particularly of crystallographic defects, being created in the semiconductor structure contributes to the reduction of costs also through the elimination of intermediate testing steps.

The prior-art document US 2022/059658 discloses a silicon carbide substrate and epitaxial layer including a first silicon carbide layer, a second silicon carbide layer, a third silicon carbide layer, a fourth silicon carbide layer and a fifth silicon carbide layer, wherein the first silicon carbide layer is a buffer layer.

The prior-art document US 10.858.757 discloses an epitaxial substrate including a single-crystal substrate of silicon carbide and an epitaxial layer of silicon carbide disposed on the single-crystal substrate. The epitaxial layer includes a first epitaxial layer disposed on the single-crystal substrate, a second epitaxial layer disposed on the first epitaxial layer, and a third epitaxial layer disposed on the second epitaxial layer, wherein the first epitaxial layer and the second epitaxial layer are buffer layers.

The prior-art document US 2023/118623 discloses a silicon carbide substrate onto which at least two adjacent layers of silicon carbide films are formed as a buffer layer, and an epitaxial layer formed on the buffer layer.

### Summary of the invention

The inventors of the present patent application have developed a process for producing silicon carbide SIC substrates which reduces the incidence of crystallographic defects to < 1 ppm.

### Object of the invention

In a first object, the present invention describes a process for producing silicon carbide substrates.

In a second object, the present invention describes silicon substrates obtained with the process of the invention.

Electronic devices comprising semiconductors obtained in accordance with the present invention represent further objects.

### Brief description of the drawings

Figure 1 shows the diagram of a silicon carbide substrate produced according to the prior art.

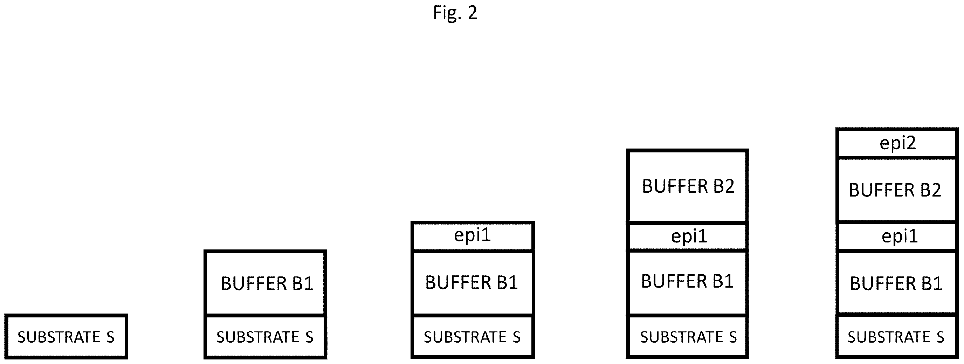

Figure 2 shows the steps of producing a substrate according to the present invention, where figure 2E shows the diagram of the final substrate.

### Detailed description of the invention

In accordance with a first object of the invention, a process for producing silicon carbide substrates is described.

In particular, the process comprises the steps of:
1) growing a first buffer layer B1 on a substrate S,
2) growing a first epitaxial layer epi1 above said first buffer layer B1,
3) growing a second buffer layer B2 above said first epitaxial layer epi1,
4) growing a second epitaxial layer epi2 (or final epitaxial layer) above said second buffer layer B2.

For the purposes of the present invention, the substrate S on which the process is carried out is a commercial substrate used in the manufacture of semiconductors.

The thickness of such a substrate S is typically up to 300 µm.

In an aspect of the invention, the substrate S has an electrical resistivity up to 10 mOhm.

As for step 1) of growing the first buffer layer B1, according to a first embodiment of the invention, this is carried out using a first process gas containing a doping agent at a first concentration (c1).

For the purposes of the present invention, the first process gas may comprise a gas selected from: SiHCl₃, SiH₄, Si₂H₆, H₂SiCl₂, Teos (tetraethyl orthosilicate) .

The first process gas may comprise a gas selected from: alkanes (C₃H₈ and other alkanes CₙH₂ₙ₊₂), alkenes (CₙH₂ₙ), alkynes (CₙH₂ₙ₋₂).

The flow rate of the first process gas may be 10-25 sccm (standard cubic centimeters per minute).

The first process gas may be C₂H₄.

For instance, C₂H₄ may have a flow rate of 10-25 sccm.

The first process gas may further comprise hydrogen H₂.

The flow rate of hydrogen may be 35-60 sccm.

The first process gas can comprise Ar as a carrier.

The first process gas can further comprise HCl and ClF₄ as catalysts and for surface cleaning.

The doping agent in the first process gas is nitrogen and said first concentration is up to 0.5% or up to 1%.

For the purposes of the present invention, in step 1) of growing the first buffer layer B1, a carbon/silicon C/Si ratio of up to 3 is used.

In a preferred aspect of the invention, the first buffer layer B1 has a number of carriers (N) per cm³, occasionally referred to as "electrical resistivity", up to 1E19 cm⁻³, and preferably between 1E17 cm⁻³ and 1E19 cm⁻³

Expressing the electrical resistivity as number of carrier (N) per cm³ is common practice in the field (in particular, the higher the number of carriers the lower the resistivity).

The growth rate of the first buffer layer B1 is about 4-60 pm/h and preferably of about 4-10 pm/h.

The process temperature for the growth of the first buffer layer B1 is about 1500-1700°C.

The process pressure for the growth of the first buffer layer B1 is about 50-300 mbar.

The residence time in the chamber is less than one hour.

For the purposes of the present invention, the first buffer layer B1 has a thickness between about 0.1-3 µm.

As for step 2) of growing the first epitaxial layer epi1, according to a first embodiment of the invention, this is carried out by employing a second process gas containing a doping agent at a second concentration (c2).

For the purposes of the present invention, the second process gas may comprise a gas selected from: SiHCl₃, SiH₄, Si₂H₆, H₂SiCl₂, Teos (tetraethyl orthosilicate) .

The second process gas may comprise a gas selected from: alkanes (C₃H₈ and other alkanes CₙH₂ₙ₊₂), alkenes (CₙH₂ₙ), alkynes (CₙH₂ₙ₋₂).

The flow rate of the second process gas may be about 30-75 sccm.

The second process gas may be C₂H₄.

For instance, C₂H₄ may have a flow rate of about 30-75 sccm.

The second process gas may further comprise hydrogen H₂.

The flow rate of hydrogen may be about 70-120 sccm.

The second process gas can comprise Ar as a carrier.

The second process gas can further comprise HCl and ClF₄ as catalysts and for surface cleaning.

The doping agent in the second process gas is nitrogen and said second concentration is up to 0.5% or up to 1%.

For the purposes of the present invention, in step 2) of growing the first epitaxial layer epi1, a carbon/silicon C/Si ratio of up to 2 is used.

In a preferred aspect of the invention, the first epitaxial layer epi1 has a number of carriers (N) per cm³ up to 1E17 cm⁻³, and preferably between 1E15 cm⁻³ and 1E17 cm⁻³.

The growth rate of the first epitaxial layer epi1 is about 4-60 pm/h and preferably 20-40 pm/h.

The process temperature for the growth of the first epitaxial layer epi1 is about 1500-1700°C.

The process pressure for the growth of the first epitaxial layer epi1 is about 50-300 mbar.

The residence time in the chamber is less than one hour.

For the purposes of the present invention, the first epitaxial layer ep1 has a thickness between about 0.1-1 µm.

It is therefore defined as a thin epitaxial layer.

As for step 3) of growing the second buffer layer B2, this is carried out employing a third process gas containing a doping agent at a third concentration (c3).

For the purposes of the present invention, the third process gas can comprise a gas selected from: SiHCl₃, SiH₄, Si₂H₆, H₂SiCl₂, Teos (tetraethyl orthosilicate) .

The third process gas may comprise a gas selected from: alkanes (C₃H₈ and other alkanes CₙH₂ₙ₊₂), alkenes (CₙH₂ₙ), alkynes (CₙH₂ₙ₋₂).

The flow rate of the third process gas may be about 10-25 sccm.

The third process gas may be C₂H₄.

For instance, C₂H₄ may have a flow rate of about 10-25 sccm.

The third process gas may further comprise hydrogen H₂.

The flow rate of hydrogen may be about 35-60 sccm.The third process gas can comprise Ar as a carrier.

The third process gas can further comprise HCl and ClF₄ as catalysts and for surface cleaning.

The doping agent in the third process gas is nitrogen and said third concentration is up to 0.5% or up to 1%.

For the purposes of the present invention, in step 3) of growing the second buffer layer B2, a carbon/silicon C/Si ratio of up to 3 is adopted.

In a preferred aspect of the invention, the second buffer layer B2 has a number of carriers (N) per cm³ up to 1E19 cm⁻³ or up to 1E20 cm⁻³, and preferably between 1E17 cm⁻³ and 1E19 cm⁻³.

The growth rate of the second buffer layer B2 is about 4-60 pm/h and preferably of about 4-10 pm/h.

The process temperature for the growth of the second buffer layer is about 1500-1700°C.

The process pressure for the growth of the second buffer layer is about 50-300 mbar.

The residence time in the chamber is less than one hour.

For the purposes of the present invention, the second buffer layer B2 has a thickness between about 0.1-2 µm.

As for step 4) of growing the second epitaxial layer epi2, according to a first embodiment of the invention, this is carried out using a fourth process gas containing a doping agent at a fourth concentration (c4).

For the purposes of the present invention, the fourth process gas can comprise a gas selected from: SiHCl₃, SiH₄, Si₂H₆, H₂SiCl₂, Teos (tetraethyl orthosilicate).

The fourth process gas may comprise a gas selected from: alkanes (C₃H₈ and other alkanes CₙH₂ₙ₊₂), alkenes (CₙH₂ₙ), alkynes (CₙH₂ₙ₋₂).

The flow rate of the fourth process gas may be about 40-100 sccm.

The fourth process gas may be C₂H₄.

For instance, C₂H₄ may have a flow rate of about 40-100 sccm.

The fourth process gas may further comprise hydrogen H₂.

The flow rate of hydrogen may be about 70-200 sccm.

The fourth process gas can comprise Ar as a carrier.

The fourth process gas can further comprise HCl and ClF₄ as catalysts and for surface cleaning.

For the purposes of the present invention, in step 4) of growing the second epitaxial epi2, a carbon/silicon C/Si ratio of up to 2 is adopted.

The doping agent in the fourth process gas is nitrogen and said fourth concentration is up to 0.5% or up to 1%.

In a preferred aspect of the invention, the second epitaxial layer epi2 has an electrical resistivity up to 1E17 cm⁻³, and preferably between 1E15 cm⁻³ and 1E17 cm⁻³.

The growth rate of the second epitaxial layer epi2 is 3 to 6 times higher than the growth rate of buffer layers B1 and B2.

The growth rate of the second epitaxial layer epi2 is about 3-60 and preferably of 20-40 pm/h.

The process temperature for the growth of the second epitaxial layer epi2 is about 1500-1700°C.

The process pressure for the growth of the second epitaxial layer epi2 is about 50-300 mbar.

The residence time in the chamber is less than one hour.

For the purposes of the present invention, the second epitaxial layer epi2 has a thickness up to 100 µm.

Preferably, the second epitaxial layer epi2 has a thickness of about 3-100 µm and may be used in applications with high tensions (10,000 Volt) or specific detectors.

More preferably, the second epitaxial layer epi2 has a thickness of about 5-15 µm and may be used in diodes at 600, 800, 1000 or 1500 Volt.

According to the present invention, the doping agent used in the process above disclosed has a first concentration and a third concentration, wherein each one of them is higher, and preferably independently higher, than each of the second concentration and the fourth concentration.

According to one embodiment of the present invention, the process gas in steps 1), 2), 3) and 4) comprises C₂H₄ and hydrogen, which is subject to a flow rate as below reported:

| step | C₂H₄ flow rate (sscm) | hydrogen flow rate (sccm) | growing rate (µm/h) |
|---|---|---|---|
| 1) and 3) | 10-25 | 35-60 | 4-10 |
| 2) | 30-75 | 70-120 | 4-60 |
| 4) | 40-100 | 70-200 | 20-40 |

In accordance with a first aspect of the present invention, the above-described process is of the integrated and continuous type.

This means that the initial substrate S is introduced into the reactor inside which all the steps of the process are carried out, directly obtaining the final product, extracted from the reactor at the end of the process.

In accordance with another aspect of the invention, the process described above is of the discontinuous type.

This means that after each process step or after one, two, or three consecutive process steps, the substrate is extracted from the reactor, cooled, and then inserted back into the reactor for the subsequent step(s).

In a second object of the invention, the present patent application discloses silicon substrates obtained with the process of the invention.

In particular, said substrates comprise a number of crystallographic defects in the second epitaxial layer epi2 of <1 ppm.

According to further objects of the present invention, there are described electronic devices comprising the semiconductors obtained with the above process.

The process described by the present patent application has demonstrated to produce better substrates, such as to improve the electrical performance and reliability of the devices incorporating them.

These improvements contribute to improving the electrical performance and reliability of the devices.

Moreover, the mechanical performance of the devices being manufactured is also improved (the improvement is of the order a few percent), so as to offer a great advantage, because the cost of the silicon carbide substrate in the manufacturing process is of the order of 60%-80%.

## Claims

1. A process for producing silicon carbide (SiC) substrates, comprising the steps of:
1) growing a first buffer layer (B1) on a substrate (S) using a first process gas comprising a first concentration of doping agent,
2) growing a first epitaxial layer (epi1) above said layer (B1) using a second process gas comprising a second concentration of doping agent,
3) growing a second buffer layer (B2) above said first epitaxial layer (epi1) using a third process gas comprising a third concentration of doping agent,
4) growing a second epitaxial layer (epi2) above said second buffer layer (B2) using a fourth process gas comprising a fourth concentration of doping agent.

2. A process according to the preceding claim, wherein said first, second, third and fourth process gases comprise a gas selected from: SiHCl₃, SiH₄, Si₂H₆, H₂SiCl₂, Teos (tetraethyl orthosilicate).

3. A process according to claim 1 or 2, wherein said first, second, third and fourth process gases are selected from: alkanes, alkenes, alkynes.

4. A process according to any one of the preceding claims, wherein in step 1) and in step 3) each of said first process gas and third process gas is independently flown at a flow rate of 10-25 sccm.

5. A process according to any one of the preceding claims, wherein in step 2) said second process gas is flown at a flow rate of 30-75 sccm.

6. A process according to any one of the preceding claims, wherein in step 4) said fourth process gas is flown at a flow rate of 40-100 sccm.

7. A process according to any one of the preceding claims, wherein each one of said first, second, third and fourth process gas may independently comprise hydrogen.

8. A process according to the preceding claim, wherein in step 1) and in step 3) hydrogen is flown at a flow rate of 35-60 sccm.

9. A process according to claim 7, wherein in step 2) hydrogen is flown at a flow rate of 70-120 sccm.

10. A process according to any one of the preceding claims, wherein in step 4) hydrogen is flown at a flow rate of 70-200 sccm.

11. A process according to any one of the preceding claims, wherein said first, second, third and fourth concentrations of doping agent are up to 0.5% or up to 1%.

12. A process according to any one of the preceding claims, wherein each of said first and third concentration of doping agent is independently higher than each of said second and fourth concentration of doping agent.

13. A process according to any one of the preceding claims, wherein the growth rate of steps 1), and 3) is 4-60 pm/h and preferably of about 4-10 pm/h.

14. A process according to any one of the preceding claims, wherein the growth rate of step 4) is 3-60 pm/h and preferably of 20-40 pm/h.

15. A process according to any one of the preceding claims, wherein in steps 1) and 3) a carbon/silicon ratio up to 3 is adopted.

16. A process according to any one of the preceding claims, wherein in steps 2) and 4) a carbon/silicon ratio up to 2 is adopted.

17. A process according to any one of the preceding claims, which is carrier out continuously or discontinuously.

18. A process according to any one of the preceding claims, wherein the second epitaxial layer (epi2) is grown until a thickness of up to 100 µm.

19. A substrate obtained by the process according to any one of the preceding claims, comprising a number of crystallographic defects < 1 ppm in the second epitaxial layer (epi2).
